# EUROPÄISCHE PATENTANMELDUNG

(11) **EP 3 038 214 A1**
(43) Veröffentlichungstag der Anmeldung: **29.06.2016**
(21) Anmeldenummer: 15200259.8
(22) Anmeldetag: 15.12.2015
(51) Int. Cl.: H01R 12/70, H01R 12/71, H01R 33/05

(54) **STECKFASSUNG FÜR EIN ELEKTRISCHES BAUTEIL, INSBESONDERE EINEN STECKVERBINDER ODER EINE ANTENNE**

(30) Priorität: 23.12.2014 DE 102014226984
(71) Anmelder: Power Plus Communications AG, 68167 Mannheim (DE)
(72) Erfinder: SILLE, Inga, 68159 Mannheim (DE); VESELCIC, Marko, 67122 Altrip (DE)
(74) Vertreter: Patent- und Rechtsanwälte Ullrich & Naumann

(57) **Zusammenfassung**

Es ist eine Steckfassung (1, 1') für ein elektrisches Bauteil, insbesondere einen Steckverbinder (11) oder eine Antenne, offenbart. Das Bauteil weist mindestens ein Anschlussbein (12) auf. Die Steckfassung (1, 1') umfasst einen Grundkörper (2) mit einer Oberseite (3), einer Unterseite (4) und mindestens einer Durchführung (5) zur Aufnahme des Anschlussbeins (12)/eines der Anschlussbeine (12). An der Unterseite (3) des Grundkörpers (4) ist mindestens ein Anschlussmittel (6) zum elektrischen Kontaktieren mit mindestens einer Leiterbahn auf einer Platine (15), insbesondere einer Platine (15) für eine Kommunikationseinheit, angeordnet. Die Durchführung/en (5) erstreckt/erstrecken sich von einer Seite des Grundkörpers (2) zu einer anderen Seite des Grundkörpers (2) und ist/sind derart ausgebildet, dass das Bauteil in beide Enden der Durchführung/en (5) einsteckbar ist. In der Durchführung (5)/in mindestens einer der Durchführungen (5) ist ein elektrisch leitfähiger Bereich ausgebildet, der ein eingestecktes Anschlussbein (12) elektrisch kontaktiert und eine elektrisch leitfähige Verbindung zwischen dem eingesteckten Anschlussbein (12) und dem Anschlussmittel (6)/mindestens einem der Anschlussmittel (6) herstellt. Des Weiteren ist eine Kommunikationseinheit, insbesondere SmartMeter-Gateway, mit einer Platine (15) und der Steckfassung (1, 1') vorgesehen. Die Kommunikationseinheit stellt eine Verbindung zwischen zwei Netzwerken, insbesondere einem lokalen Netzwerk und einem Weitbereichsnetzwerk, her. Die Steckfassung (1, 1') ist mit der Platine (15) verbunden. In die Steckfassung (1) sind Anschlussbeine (12) eines elektrischen Bauteils, insbesondere eines Steckverbinders (11) oder einer Antenne, einsteckbar. Das elektrische Bauteil dient als Schnittstelle zu einem der beiden Netzwerke.

## Beschreibung

Die Erfindung betrifft eine Steckfassung für ein elektrisches Bauteil, insbesondere einen Steckverbinder oder eine Antenne. Des Weiteren betrifft die Erfindung eine Kommunikationseinheit, insbesondere einen SmartMeter-Gateway, mit einer Platine und einer entsprechenden Steckfassung.

Aus der Praxis bekannte Kommunikationseinheiten stellen üblicherweise eine Verbindung zwischen zwei Schnittstellen her. Die Kommunikationseinheiten sind meist in Gehäusen angeordnet und sind als Elektrobaugruppe/n auf einer oder mehreren Platinen aufgebaut. Die Ausgestaltung der Schnittstellen ergibt sich meist aus der Verwendung der Kommunikationseinheit. So kann beispielsweise eine Verbindung zwischen einer USB (Universal Serial Bus)- und einer Ethernet-Schnittstelle hergestellt werden, wobei die Kommunikationseinheit dann als Netzwerk-Adapter ausgebildet ist. Eine andere Kommunikationseinheit ist beispielsweise ein PLC (Powerline Communication)-Modem, das eine Verbindung zwischen einem Ethernet-Gerät und einem auf dem Stromversorgungsnetzwerk aufgespannten Kommunikationskanal herstellt. Ein weiteres Beispiel für eine derartige Kommunikationseinheit ist ein SmartMeter-Gateway, auf das nachfolgend beispielhaft näher eingegangen wird.

Ein SmartMeter-Gateway stellt eine Verbindung zwischen einer Weitbereichsschnittstelle, beispielsweise durch PLC implementiert, und weiteren Schnittstellen her, über die beispielsweise ein oder mehrere SmartMeter (elektronischer Verbrauchszähler beispielsweise für elektrische Energie) verbunden sind. Der Aufbau eines SmartMeter-Gateways ist prinzipiell relativ beliebig. In Deutschland existieren allerdings Regelungen, die Aspekte eines SmartMeter-Gateways detailliert festlegen. Das Gesetz über die Elektrizitäts- und Gasversorgung (EnWG) und dort insbesondere die §§ 21 e, 21f und 21i schreiben gewisse Ausgestaltungen vor, die in einem Schutzprofil und einer Technische Richtlinie des Bundesamts für Sicherheit in der Informationstechnik (BSI) weiter konkretisiert sind. Danach verbindet ein SmartMeter-Gateway die im Lokalen Metrologischen Netzwerk (LMN) angeordneten SmartMeter mit dem lokalen Heimnetzwerk (HAN) und verschiedenen Marktteilnehmern (beispielsweise SmartMeter-Gateway-Administrator, Verteilnetzbetreiber oder Messstellenbetreiber) im Weitbereichsnetzwerk (WAN).

Für die gerätetechnische Umsetzung der rechtlichen Vorgaben hat das FNN (Forum Netztechnik und Netzbetrieb) im VDE (Verband der Elektrotechnik, Elektronik und Informationstechnik e.V.) das Lastenheft "FNN MS2020 - Lastenheft Konstruktion, Basiszähler und SmartMeter-Gateway" (MS2020 = Messsystem2020) veröffentlicht. In dem Lastenheft ist festgelegt, dass die Schnittstelle des SmartMeter-Gateway zum LMN als drahtgebundene Schnittstelle nach dem RS 485 Standard und als drahtlose Schnittstelle nach der wireless M-Bus (Meter-Bus)-Norm ausgebildet ist. Die für die wireless M-Bus-Schnittstelle notwendige Antenne ist als interne Antenne in dem SmartMeter-Gateway ausgebildet oder ist als externe Antenne mittels eines Steckverbinders mit dem SmartMeter-Gateway verbunden. Bei Bereitstellen eines Steckverbinders muss dieser als Fakra (Fachkreis Automobil)-Steckverbinder in Kodierung C ausgebildet sein. An dem SmartMeter-Gateway ist demnach eine Fakra-Buchse C (in signalblau) vorgesehen, in die zur Verbindung mit einer Antenne ein Fakra-Stecker C einsteckbar ist.

In der Praxis sind SmartMeter-Gateways meist in Hutschienengehäusen aufgebaut, die an einer Hutschiene beispielsweise in einem Elektroverteiler oder einem Schaltschrank montierbar ist. In vielen Fällen ist der SmartMeter, der mit dem SmartMeter-Gateway kommunizieren soll, in demselben Raum angeordnet wie der SmartMeter-Gateway. Wenn die Entfernung zwischen SmartMeter-Gateway und SmartMeter nicht allzu groß ist, genügt sehr häufig eine interne Antenne des SmartMeter-Gateways, d.h. eine Antenne, die in das Gehäuse des Gateways integriert ist. In einigen Installationssituationen mit vielen dämpfenden Hindernissen, beispielweise einer Metalltür des Schaltschranks oder einer Stahlbeton-Wand, kann die Reichweite der internen Antenne für eine ausreichend stabile Kommunikation zwischen SmartMeter und SmartMeter-Gateway zu gering sein. Daher ist in der Praxis stets neben einer internen Antenne eine Fakra-Buchse vorhanden, an die im Bedarfsfall eine externe Antenne angeschlossen werden kann. Nachteilig daran ist, dass durch das Bereitstellen zweier Bauteile - (interne) Antenne und Steckverbinder - zusätzliche Kosten entstehen und ohnehin nur sehr beschränkt verfügbarer Platz innerhalb des Gehäuses verbraucht wird.

Dieses Problem könnte dadurch gelöst werden, dass SmartMeter-Gateways bereitgestellt werden, die entweder eine interne Antenne oder einen Steckverbinder aufweisen. Nachteilig daran ist, dass sich in der Praxis häufig erst nach Installation des SmartMeter-Gateways zeigt, ob eine interne Antenne genügt oder nicht. Daher müsste entweder im Zweifelsfall direkt ein Gateway mit Steckverbinder eingebaut oder ein Gateway mit interner Antenne wieder ausgebaut und gegen ein Gateway mit Steckverbinder getauscht werden. Ersteres erzeugt durch die möglicherweise unnötige externe Antenne zusätzliche Kosten und Platzbedarf für die Antenne. Die zweitgenannte Option erzeugt zusätzlichen Installationsaufwand. Des Weiteren ist in SmartMeter-Gateways üblicherweise ein elektronischer Schlüssel installiert, der eine Aktivierung des Gateways innerhalb einer bestimmten Zeitspanne nach dessen Fertigung erfordert. Daher sind SmartMeter-Gateways nur begrenze Zeit lagerfähig, so dass die Bereitstellung von zwei unterschiedlichen Varianten nicht unproblematisch ist.

Es wäre zwar prinzipiell denkbar, dass eine Steckfassung vorgesehen ist, in die abhängig von dem jeweiligen Installationsort des SmartMeter-Gateways entweder eine interne Antenne oder ein Steckverbinder eingesteckt wird. Problematisch ist aber, dass keine Steckfassungen verfügbar sind, die für diesen Einsatzzweck geeignet wären und die gleichzeitig ausreichend kostengünstig und flexibel einsetzbar sind. Da zusätzlich SmartMeter-Gateways nach der Herstellung versiegelt werden und nicht mehr geöffnet werden dürfen, entstehen weitere Randbedingungen, die an eine Steckfassung zu stellen sind.

Ähnliche Problemstellung treten auch bei anderen Kommunikationseinheiten auf.

Der vorliegenden Erfindung liegt daher die Aufgabe zugrunde, eine Kommunikationseinheit, insbesondere einem SmartMeter-Gateway, sowie eine zur Verwendung in einer derartigen Kommunikationseinheit geeignete Steckfassung für ein elektrisches Bauteil derart anzugeben und weiterzubilden, dass eine möglichst flexible Einsetzbarkeit bei gleichzeitig einfacher Installation möglich ist.

Erfindungsgemäß wird die voranstehende Aufgabe durch die Merkmale des Anspruchs 1 gelöst. Danach weist das Bauteil mindestens ein Anschlussbein und die Steckfassung einen Grundkörper mit einer Oberseite, einer Unterseite und mindestens einer Durchführung zur Aufnahme des Anschlussbeins/eines der Anschlussbeine auf. An der Unterseite des Grundkörpers ist mindestens ein Anschlussmittel zum elektrischen Kontaktieren mit mindestens einer Leiterbahn auf einer Platine, insbesondere einer Platine für eine Kommunikationseinheit, angeordnet. Die Durchführung/en erstreckt/erstrecken sich von einer Seite des Grundkörpers zu einer anderen Seite des Grundkörpers und ist/sind derart ausgebildet, dass das Bauteil in beide Enden der Durchführung/en einsteckbar ist. In der Durchführung /in mindestens einer der Durchführungen ist ein elektrisch leitfähiger Bereich ausgebildet, der ein eingestecktes Anschlussbein elektrisch kontaktiert und eine elektrisch leitfähige Verbindung zwischen dem eingesteckten Anschlussbein und dem Anschlussmittel/ mindestens einem der Anschlussmittel herstellt.

Hinsichtlich der Kommunikationseinheit, insbesondere Smartmeter-Gateway, mit einer Platine und einer entsprechenden Steckfassung ist die Aufgabe durch die Merkmale des Anspruchs 15 gelöst. Die Kommunikationseinheit stellt eine Verbindung zwischen zwei Netzwerken, insbesondere einem lokalen Netzwerk und einem Weitbereichsnetzwerk, her. Die Steckfassung ist mit der Platine verbunden. In die Steckfassung sind Anschlussbeine eines elektrischen Bauteils, insbesondere eines Steckverbinders oder einer Antenne, einsteckbar. Das elektrische Bauteil dient als Schnittstelle zu einem der zwei Netzwerke.

In erfindungsgemäßer Weise ist zunächst erkannt worden, dass zur Gewährleistung des Betriebs der Kommunikationseinheit an einem beliebigen Einsatzort nicht zwingend mehrere elektrische Bauteile, die im Wesentlichen dem selben Zweck dienen, auf der Platine der Kommunikationseinheit angeordnet sein müssen. Vielmehr ist erkannt worden, dass am Einsatzort der Kommunikationseinheit während deren Betrieb lediglich ein elektrisches Bauteil der mehreren demselben Zweck dienenden elektrischen Bauteile Verwendung findet. Die anderen elektrischen Bauteile bleiben jedoch unbenutzt. Im Falle der Kommunikationseinheit in Form eines SmartMeter-Gateways wird eine externe Antenne lediglich dann über einen Steckverbinder mit dem SmartMeter-Gateway verbunden, wenn die Reichweite einer internen Antenne zum Herstellen einer stabilen Kommunikationsverbindung mit den SmartMetern nicht ausreicht. In der Praxis ist dies lediglich an ca. 20% der Einsatzorte des SmartMeter-Gateways der Fall. Daraus ergibt sich, dass die interne Antenne an 20% der Einsatzorte bzw. der Steckverbinder an 80% der Einsatzorte unbenutzt verbleibt.

Daher ist erfindungsgemäß eine Steckfassung vorgesehen, über die wahlweise Anschlussbeine verschiedener elektrischer Bauteile mit Leiterbahnen einer Platine der Kommunikationseinheit elektrisch verbindbar sind. Die Steckfassung ist nachträglich bei Installation der Kommunikationseinheit mit der Platine der bereits industriell produzierten Kommunikationseinheit verbindbar oder ist bereits auf der Platine angebracht. So kann in Kenntnis des jeweiligen Einsatzorts der Kommunikationseinheit das jeweilige am Einsatzort benötigte elektrische Bauteil über die Steckfassung mit der Platine der Kommunikationseinheit verbunden werden. Für die Steckfassung ist unabhängig von dem jeweiligen elektrischen Bauteil eine Stelle auf der Platine vorgesehen, die vorzugsweise in einem Randbereich der Platine angeordnet ist. An dem Gehäuse der Kommunikationseinheit kann eine entsprechende Aussparung vorgesehen sein, in die das jeweilige Bauteil eingesetzt und in die Steckfassung eingesteckt werden kann. Dadurch ist das Bauteil ohne ein Öffnen des Gehäuses mit der Platine verbindbar. Durch das Anordnen lediglich einer Steckfassung auf der Platine der Kommunikationseinheit, die die Anschlussbeine verschiedener an unterschiedlichen Einsatzorten verwendeter elektrischer Bauteile aufzunehmen vermag, werden die Kosten der an dem jeweiligen Einsatzort nicht verwendeten elektrischen Bauteile eingespart.

Bei der bevorzugten Ausgestaltung der Kommunikationseinheit als SmartMeter-Gateway ist die Steckfassung sowohl zur Aufnahme der Anschlussbeine einer Fakra-Buchse (oder allgemein: eines Steckverbinders) als auch der internen Antenne geeignet, die Bauteile in Sinne der vorliegenden Erfindung sind. Dadurch werden abhängig vom Einsatzort in 20% der Fälle die Kosten für die interne Antenne und in 80% der Fälle die Kosten für die Fakra-Buchse eingespart. Zusätzlich reduziert sich die benötigte Fläche auf der Platine, da entweder der Platz für die Buchse oder der Platz für die interne Antenne eingespart wird.

Im Konkreten weist die Steckfassung einen Grundkörper mit einer Oberseite und einer Unterseite auf. Als Unterseite wird die Seite des Grundkörpers betrachtet, die einer Platine bei Installation der Steckfassung auf der Platine zugewandt ist. Entsprechend ist an der Unterseite mindestens ein Anschlussmittel ausgebildet, das einen elektrischen Kontakt zu mindestens einer Leiterbahn auf der Platine herstellen kann. Die Oberseite ist die der Unterseite im Wesentlichen gegenüberliegende Seite des Grundkörpers. Zudem weist die Steckfassung mindestens eine Durchführung auf. Die mindestens eine Durchführung erstreckt sich von einer Seite des Grundkörpers zu einer anderen Seite des Grundkörpers. Je nach Ausgestaltung der Durchführung ist damit sowohl eine abgewinkelte Ausgestaltung der Steckfassung als auch eine nicht-abgewinkelte Ausgestaltung möglich. Dadurch lassen sich unterschiedliche Steckfassungen für unterschiedliche Installationsszenarien ausbilden. In der mindestens einen Durchführung ist ein elektrisch leitfähiger Bereich ausgebildet, der mit dem Anschlussmittel bzw. mit einem oder mehreren der Anschlussmittel elektrisch verbunden ist. Das Anschlussbein bzw. jedes der mehreren Anschlussbeine ist von beiden Enden der Durchführungen einsteckbar, d.h. das mindestens eine Anschlussbein kann von beiden Seiten des Grundkörpers aus, zwischen denen sich die mindestens eine Durchführung erstreckt eingesteckt werden. Dies trägt zu einem flexibleren Einsatz der Steckfassung bei.

In einer bevorzugten Ausgestaltung erstreckt sich die Durchführung bzw. jede der Durchführungen von der Oberseite des Grundkörpers zu der Unterseite des Grundkörpers. Auf diese Weise lassen sich verschiedenste Ausgestaltungen realisieren, bei denen die Anschlussbeine des elektrischen Bauteils in einem Winkelbereich um die Normale zu der Platine, mit der die Steckfassung verbunden wird, angeordnet sind.

Der Grundkörper selbst kann verschiedenste geometrische Formen aufweisen. Denkbar wäre beispielsweise, den Grundkörper als Zylinder auszuformen, wobei dessen Deck- bzw. Grundfläche des Zylinders der Ober- bzw. der Unterseite des Grundkörpers entsprechen würde. Auch denkbar ist eine Ausgestaltung des Grundkörpers als relativ beliebig gestalteter Polyeder. Symmetrische Körper können ebenso zum Einsatz kommen wie nicht-symmetrische Körper. Die einzelnen Seiten des Grundkörpers können sowohl gebogen als auch eben ausgestaltet sein. Hinsichtlich einer stabilen Befestigung des Grundkörpers auf der Platine ist es jedoch sinnvoll, wenn zumindest die Unterseite des Grundkörpers eben ausgebildet ist. Vorzugsweise ist der Grundkörper jedoch quaderförmig ausgebildet. Besonders bevorzugt weist der Quader eine quadratische Ober- und Unterseite auf, wobei die Höhe bzw. Tiefe des Quaders höchstens einem Drittel der Länge einer Seitenkante der Ober- und Unterseite entspricht.

Die Durchführung kann im Wesentlichen geradlinig oder gekrümmt verlaufen. Der Querschnitt der Durchführung bzw. einer der mehreren Durchführungen kann verschiedenste geometrische Formen aufweisen. Denkbar ist beispielsweise, dass der Querschnitt polygonal, elliptisch oder kreisförmig ausgebildet ist. Der jeweilige Querschnitt kann in Form und Fläche über die gesamte Länge der Durchführung bzw. der Durchführungen konstant sein. Der Querschnitt kann sich jedoch auch längs der Durchführung/en verändern. So kann sich beispielsweise eine Durchführung bei Erstreckung von der Ober- zur Unterseite in Richtung der Oberseite oder in Richtung der Unterseite verjüngen, insbesondere konisch zulaufen. Eine derartige Verjüngung kann über die Länge der Durchführung ein Maximum aufweisen, wobei sich die Durchführung nach dem Maximum wieder aufweitet. Durch eine Verjüngung des Querschnitts der Durchführung bzw. Durchführungen kann über die Innenwandung der Durchführung eine Klemmwirkung gegenüber dem in die Durchführung eingesteckten Anschlussbein erzielt werden. Vorzugsweise ist der Querschnitt der Durchführung/en kreisförmig ausgebildet und bleibt längs der Durchführung/en in Form und Fläche weitgehend konstant, so dass die Durchführung/en zylinderförmig ausgebildet ist/sind.

Der leitfähige Bereich kann durch eine leitfähige Beschichtung an der Innenwandung der Durchführung bzw. einer der mehreren Durchführungen gebildet sein. Die Innenwandung kann lediglich in einzelnen Bereichen oder vollständig beschichtet sein. Zur leitfähigen Beschichtung der Innenwandung können aus dem Stand der Technik bekannte Beschichtungsverfahren, wie beispielsweise Sputterdeposition, plasmaunterstützte chemische Gasphasenabscheidung, thermisches Spritzen oder Galvanisieren Anwendung finden. Eine mögliche Ausgestaltung ist auch, dass die Beschichtung an der Innenseite der Durchführung spritzgusstechnisch ausgespritzt ist und aus einem Material besteht, dem leitfähige Partikel beigemischt sind.

Ebenso ist es denkbar, dass der leitfähige Bereich durch eine in der Durchführung bzw. jeweils eine in den mehreren Durchführungen angeordnete elektrisch leitfähige Hülse gebildet ist. Bei einer Ausgestaltung der Durchführung/en, die sich von der Ober- zur Unterseite erstreckt/erstrecken, kann diese Hülse über die Oberseite und/ oder die Unterseite des Grundkörpers hinausragen. Der über die Oberseite hinausragende Teil der Hülse kann einen Kragen aufweisen oder aufgeweitet sein. Bei Einstecken des Anschlussbeins an der Oberseite des Grundkörpers würde der Kragen bzw. der aufgeweitete Teil der Hülse als Rückhalt der Hülse gegenüber dem Grundkörper dienen und ein Herausrutschen der Hülse aus dem Grundköper verhindern. Die Hülse kann vorzugsweise form- und/oder kraftschlüssig mit der Durchführung bzw. einer der Durchführungen verbunden sein. Zum Erzielen einer form- und/oder kraftschlüssigen Verbindung der Hülse mit der Durchführung kann die Hülse zunächst in die Durchführung eingebracht und danach aufgeweitet werden. Zusätzlich kann die Außenmantelfläche der Hülse aufgeraut sein und/oder mit Widerhaken versehen sein. Eine derartige Ausgestaltung der Hülse begünstigt die Haftreibung zwischen der Hülse und dem Grundkörper.

In der Durchführung bzw. in einer der Durchführungen können Mittel zum kraftschlüssigen Festklemmen eines eingesteckten Anschlussbeins ausgebildet sein. Die Mittel zum kraftschlüssigen Festklemmen können auf der gesamten Fläche der Innenwandung der Durchführung oder der Innenwandung der Hülse ausgebildet sein. Ebenso ist aber auch denkbar, dass die Innenwandung der Durchführung oder der Hülse lediglich an einzelnen Bereichen mit Mitteln zum kraftschlüssigen Festklemmen versehen ist. Die Mittel zum kraftschlüssigen Festklemmen können durch ein verformbares Material gebildet sein, das bei Einstecken eines Anschlussbeins verformt wird. Dadurch entsteht eine Klemmwirkung zwischen Anschlussbein und verformbarem Material. Das verformbare Material kann als elastisches Material ausgebildet sein, das nach einem Entfernen des Anschlussbeins aus der Hülse im Wesentlichen wieder in seinen Ausgangszustand zurückkehrt.

Vorzugsweise sind die Mittel zum kraftschlüssigen Festklemmen durch ein verformbares Material in Form einer Blende oder einer Rosette gebildet sein. Bei Einstecken eines Anschlussbeins wird die Blende oder die Rosette quer zur Einsteckrichtung weggedrückt bzw. aufgeweitet und dadurch in Spannung versetzt. Die Rückstellkraft der in Spannung versetzten, aufgeweiteten Blende bzw. Rosette klemmt das eingesteckte Anschlussbein fest. Die Blende bzw. die Rosette kann aus einem aufgerauten Material bestehen und/oder mit Widerhaken versehen sein. Dadurch kann die Haftreibung zwischen einem eingesteckten Anschlussbein und der Rosette bzw. der Blende vergrößert und einem Herausrutschen oder Herausziehen des Anschlussbeins aus der Durchführung vorgebeugt werden.

Die Mittel zum kraftschlüssigen Festklemmen eines eingesteckten Anschlussbeins können elektrisch leitfähig sein. Dabei können die Mittel zum kraftschlüssigen Festklemmen vollständig aus einem elektrisch leitfähigen Material gebildet sein oder es kann ein elektrisch leitfähiges Material in ein sonst nicht-leitfähiges Material eingebettet sein, wodurch das Mittel zum kraftschlüssigen Festklemmen leitfähig wird. Ein Beispiel für die zweitgenannte Variante ist eine Ausgestaltung aus Silikon mit Eisenspänen oder ein Stoff mit eingeflochtenem Metall. Die elektrisch leitfähigen Mittel zum kraftschlüssigen Festklemmen kontaktieren ein eingestecktes Anschlussbein und sind mit dem elektrisch leitfähigen Bereich und/oder mit den Anschlussmitteln elektrisch verbunden. In diesem Sinne können die Mittel zum Festklemmen den elektrisch leitfähigen Bereich vollständig oder zumindest teilweise selbst bilden.

Bei einer Ausgestaltung der Durchführung/en, die sich von der Ober- zur Unterseite erstreckt, können die Steckfassung und das elektrische Bauteil auf derselben Seite der Platine oder auf unterschiedlichen Seiten der Platine angeordnet sein. Bei einer Anordnung auf derselben Seite der Platine kann die Steckfassung zunächst mit ihrer Unterseite zur Platine gerichtet über die Anschlussmittel mit Leiterbahnen der Platine verbunden werden. Was "verbinden" bedeutet, hängt von der Ausgestaltung des Anschlussmittels/der Anschlussmittel ab. Sodann kann das elektrische Bauteil an der Oberseite in die Steckfassung eingesteckt werden. Bei einer Anordnung auf unterschiedlichen Seiten der Platine kann die Steckfassung zunächst mit ihrer Unterseite zur Platine gerichtet über die Anschlussmittel mit Leiterbahnen der Platine verbunden werden. Das Anschlussbein/die Anschlussbeine werden durch in der Platine ausgestaltete Durchgänge geführt und an der Unterseite des Grundkörpers in die jeweilige Durchführung der Steckfassung eingesteckt. Die Anordnung des elektrischen Bauteils und der Steckfassung auf unterschiedlichen Seiten der Platine hat den Vorteil, dass sich die Einbauhöhe des elektrischen Bauteils - im Vergleich zu einem Einbau des elektrischen Bauteils ohne Steckfassung - nicht erhöht.

In einem ersten Ausführungsbeispiel der Steckfassung können sich die Anschlussmittel direkt an die Durchführung anschließen. Dabei kann das/die Anschlussmittel als Hohlzylinder ausgestaltet sein. Jeder Hohlzylinder weist dabei einen koaxial zu der zylinderförmigen Durchführung bzw. zu einer der zylinderförmigen Durchführungen ausgebildeten Innenzylinder auf. Der Durchmesser des Innenzylinders entspricht im Wesentlichen dem Durchmesser dieser Durchführung. Der Innenzylinder erweitert die zylinderförmige Durchführung dabei in ihrer Länge. In einer anderen Ausgestaltung eines derartigen Anschlussmittels kann - bei Vorhandensein einer Hülse im Inneren der Durchführung/en - das/die Anschlussmittel durch einen Teil der Hülse gebildet sind. Dieser Teil der Hülse ragt über die Unterseite des Grundkörpers hinaus. Das Anschlussmittel kann bzw. die Anschlussmittel können bei beiden Ausgestaltungen (d.h. als Hohlzylinder oder als Teil einer Hülse) derart ausgebildet sein, dass ein in die zugehörige Durchführung eingestecktes Anschlussbein die Ausdehnung des Anschlussmittels in einer Richtung quer zu der Durchführung vergrößert. Bei geeigneter Dimensionierung einer Ausnehmung in der Platine, in die das Anschlussmittel eingesteckt ist, kann sich zwischen Anschlussmittel und Durchführung sowohl eine kraftschlüssige Verbindung als auch eine elektrisch leitende Verbindung zu der Leiterbahn der Platine her. Dies wird dadurch erreicht, dass zumindest teilweise an der Innenseite des Durchgangs der Platine eine Leiterbahn angeordnet ist, so dass das durch die Platine durchgeführte und ausgedehnte Anschlussmittel diese elektrisch kontaktiert. Diese Ausgestaltung des Anschlussmittels hat den Vorteil, dass die Steckfassung auch nach Fertigung einer zugehörigen Kommunikationseinheit eingesetzt werden kann.

In einem zweiten Ausführungsbeispiel kann das Anschlussmittel bzw. können die Anschlussmittel als Lötfahne bzw. Lötfahnen ausgebildet sein. In diesem Fall wird die Steckfassung während Produktionsprozesses an eine oder mehrere Leiterbahnen angelötet. Die Lötfahnen können von dem Grundkörper abstehen und im Sinne eines SMD-Bauteils (Surface Mounted Device) auf eine Leiterbahn gelötet werden. Denkbar wären auch Lötfahnen, die sich teilweise unter den Grundkörper erstrecken. Auch diese Ausgestaltung würde eine SMD-Montage zulassen. Die Ausgestaltung der Anschlussmittel als Lötfahnen für eine SMD-Montage hat insbesondere bei einer Anordnung von Steckfassung und elektrischem Bauteil auf zwei verschiedenen Seiten der Platine Vorteile. Denkbar wäre prinzipiell auch, dass die Lötfahnen als Stifte ausgebildet sind, die in entsprechende Ausnehmungen in der Platine eingesteckt und danach verlötet werden. Zu beachten ist hierbei, dass dennoch eine Einsteckbarkeit des elektrischen Bauteils von beiden Seiten des Stecksockels erreicht werden soll. Durch Verwenden einer - wie auch immer ausgestalteten - Lötverbindung kann eine mechanisch recht stabile Verbindung erzielt werden.

Die Durchführung kann bzw. die Durchführungen können zum Einstecken der Anschlussbeine eines zweipoligen Steckverbinders ausgebildet sein. Der Steckverbinder kann ein Koaxialsteckverbinder sein. Ein Anschlussbein kann mit einer Phase beaufschlagt sein, mindestens ein anderes Anschlussbein kann mit Masse beaufschlagt sein. Das mit der Phase beaufschlagte Anschlussbein kann bei Vorsehen von mindestens zwei mit Masse beaufschlagten Anschlussbeinen den Mittelpunkt eines Kreises bilden, auf dem die mit Masse beaufschlagten Anschlussbeine angeordnet sind. Beispielsweise kann der Steckverbinder ein Fakra (Fachkreis Automobil)-Steckverbinder, vorzugsweise als Fakra-Buchse vom Typ C, sein.

Auf der Unterseite des Grundkörpers kann eine leitende Beschichtung vorgesehen sein, die bei Kontaktierung mit Leiterbahnen der Platine eine elektrische Verbindung mit den Leiterbahnen der Platine herstellt. Die leitende Beschichtung ist mit dem Anschlussmittel bzw. den Anschlussmitteln der Steckfassung elektrisch leitfähig verbunden.

Es gibt nun verschiedene Möglichkeiten, die Lehre der vorliegenden Erfindung in vorteilhafter Weise auszugestalten und weiterzubilden. Dazu ist einerseits auf die dem Anspruch 1 nachgeordneten Ansprüche und andererseits auf die nachfolgende Erläuterung bevorzugter Ausführungsbeispiele der Erfindung anhand der Figuren zu verweisen. In Verbindung mit der Erläuterung der bevorzugten Ausführungsbeispiele der Erfindung anhand der Figuren werden auch im Allgemeinen bevorzugte Ausgestaltungen und Weiterbildungen der Lehre erläutert. In den Figuren zeigt
- Fig. 1: unterschiedliche Ansichten eines ersten Ausführungsbeispiels einer erfindungsgemäßen Steckfassung mit Anschlussmitteln in Form von Hohlzylindern,
- Fig. 2: eine Seitenansicht der Steckfassung des ersten Ausführungsbeispiels und einen Steckverbinder in gerader Ausführung,
- Fig. 3: eine Seitenansicht der Steckfassung des ersten Ausführungsbeispiels und einem in die Steckfassung eingesteckten abgewinkelten Steckverbinder,
- Fig. 4: unterschiedliche Ansichten der Steckfassung des ersten Ausführungsbeispiels und einem in die Steckfassung teilweise eingesteckten Steckverbinder,
- Fig. 5: unterschiedliche Ansichten eines zweiten Ausführungsbeispiels der erfindungsgemäßen Steckfassung mit Anschlussmitteln in Form von Lötfahnen für eine SMD-Montage,
- Fig. 6 bis 8: unterschiedliche Ansichten der Steckfassung des zweiten Ausführungsbeispiels und einem in die Steckfassung eingesteckten Steckverbinder,
- Fig. 9: unterschiedliche Ansichten eines Einsatzszenariums einer Steckfassung gemäß zweitem Ausführungsbeispiel, wobei Steckfassung und Steckverbinder auf derselben Seite einer Platine angeordnet sind, und
- Fig. 10: unterschiedliche Ansichten eines Einsatzszenariums einer Steckfassung gemäß zweitem Ausführungsbeispiel, wobei Steckfassung und Steckverbinder auf unterschiedlichen Seiten einer Platine angeordnet sind.

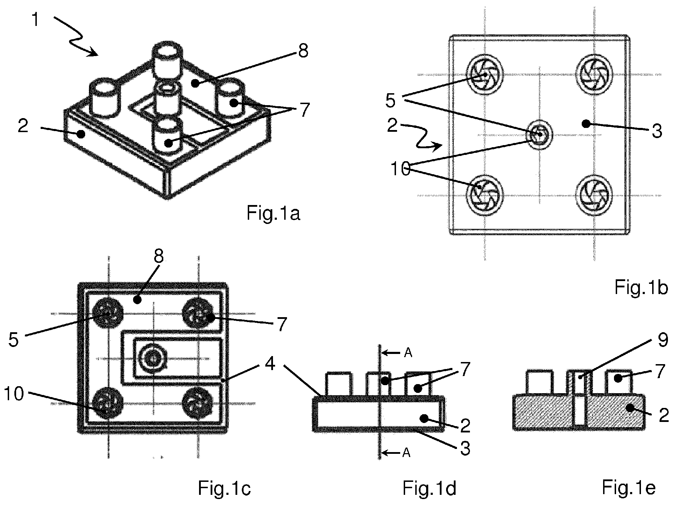

Die Figuren 1 zeigen schematische Darstellungen eines ersten Ausführungsbeispiels einer erfindungsgemäßen Steckfassung in verschiedenen Ansichten. Fig. 1a zeigt die Steckfassung 1 in einer Schrägansicht mit Blick auf die Unterseite. Fig. 1b zeigt die Steckfassung 1 in einer Draufsicht auf die Oberseite. In Fig. 1c ist eine Draufsicht auf die Unterseite der Steckfassung 1 zu erkennen. In Fig. 1d ist eine Seitenansicht und Fig. 1e eine Schnittdarstellung entlang der Schnittlinie A-A nach Fig. 1d dargestellt.

Die Steckfassung 1 weist einen quaderförmigen Grundkörper 2 mit einer Oberseite 3 und einer Unterseite 4 auf. Die Grundfläche des Grundkörpers 2 ist quadratisch ausgebildet. Die Höhe des Grundkörpers beträgt in der dargestellten Ausgestaltung ca. ¼ der Seitenlänge der Unter- bzw. Oberseite. Von der Unterseite 4 zur Oberseite 3 erstrecken sich fünf Durchführungen 5, die jeweils zylinderförmig und gerade ausgebildet sind. Eine erste Durchführung ist in der Mitte des Grundkörpers 2 angeordnet, während die vier weiteren auf einem Kreis um die erste Durchführung angeordnet sind. Bei Nutzung der Steckfassung 1 ist die erste Durchführung mit einer Phase, d.h. beispielsweise mit einem Antennensignal, und die weiteren vier Durchführungen mit Masse verbunden.

An der Unterseite 4 sind fünf Anschlussmittel 6 ausgebildet. Die Anschlussmittel 6 sind als Hohlzylinder 7 ausgestaltet. Die äußeren vier Anschlussmittel mit einer leitfähigen Beschichtung 8 auf der Unterseite 4 des Grundkörpers verbunden sind. Jeder Hohlzylinder 7 weist einen koaxial zu einer der zylinderförmigen Durchführungen 5 ausgebildeten Innenzylinder 9 auf, dessen Durchmesser im Wesentlichen dem Durchmesser der jeweiligen Durchführung 5 entspricht. Der Innenzylinder 9 erweitert damit die zylinderförmige Durchführung 5 in ihrer Länge, so dass der Bereich zur Aufnahme eines Anschlussbeins durch die Durchführung 5 selbst und den Innenzylinder 9 des Anschlussmittels 6 gebildet ist. In den Durchführungen 5 ist ein elektrisch leitfähiger Bereich in Form einer Beschichtung der Innenwandung ausgebildet. In den Durchführungen 5 sind zudem Mittel zum kraftschlüssigen Festklemmen eines eingesteckten Anschlussbeins (in Fig. 1 nicht dargestellt) vorgesehen. Die Rosette 10 kann sich dabei auch in das Anschlussmittel erstrecken, wodurch bei einstecken eines Anschlussbeins in die Rosette 10 der Außendurchmesser des Hohlzylinders in Richtungen quer zur Achse der Durchführung erweiterte wird. Die Mittel zum kraftschlüssigen Festklemmen sind durch ein verformbares Material in Form einer Rosette 10 gebildet und elektrisch leitfähig ausgestaltet. Ein jeweiliges Mittel zum kraftschlüssigen Festklemmen ist über den leitfähigen Bereich elektrisch mit einem der Anschlussmittel 6 verbunden.

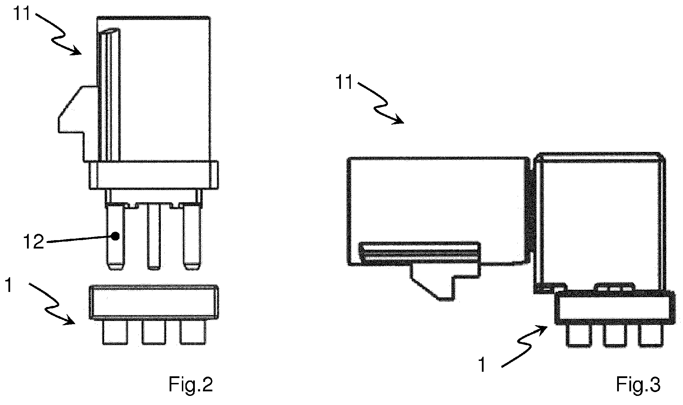

Fig. 2 zeigt die Steckfassung 1 des ersten Ausführungsbeispiels in einer Seitenansicht. Oberhalb der Steckfassung 1 ist ein elektrisches Bauteil in Form eines Steckverbinders 11 in einer Seitenansicht dargestellt. Der Steckverbinder ist als Fakra-Steckbuchse C ausgestaltet und weist fünf Anschlussbeine 12 auf. Vier Anschlussbeine 12 des Steckverbinders 11 sind mit Masse verbunden; ein Anschlussbein 12 ist mit Phase beaufschlagt. Die Anschlussbeine 12 sind dabei derart an die Steckfassung nach Fig. 1 angepasst, dass jedes Anschlussbein 12 in eine zugehörige Durchführung passt und damit der Stechverbinder in die Steckfassung eingesteckt werden kann.

Fig. 3 zeigt eine Seitenansicht einer Steckfassung 1 gemäß erstem Ausführungsbeispiel und eines in diese vollständig eingesteckten Steckverbinder 11 in einer abgewinkelten Bauform. Jedes der fünf Anschlussbeine 12 ist von der Oberseite 3 des Steckverbinders 1 in jeweils eine Durchführung 5 der Steckfassung 1 eingesteckt.

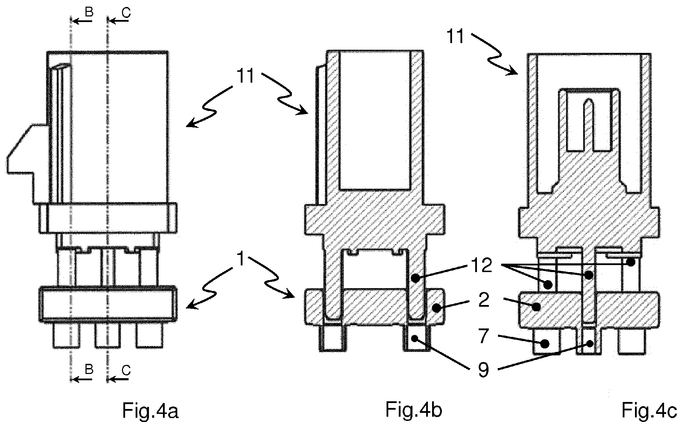

Fig. 4a zeigt eine Anordnung ähnlich der aus Fig. 2, wobei die Anschlussbeine 12 des Steckverbinders 11 teilweise in die Steckfassung 1 eingesteckt sind. Fig. 4b zeigt eine schematische Schnittdarstellung der Anordnung aus Fig. 4a entlang der Schnittlinie B-B; Fig. 4c zeigt eine schematische Schnittdarstellung der Anordnung aus Fig. 4a entlang der Schnittlinie C-C.

Statt eines Steckverbinders, wie er in den Fig. 2 bis 4 dargestellt ist, kann auch eine Antenne oder ein anderes elektrisches Bauteil in die Steckfassung eingesteckt werden. Bei einer unipolaren Antenne kann es dabei ausreichen, wenn lediglich in die erste Durchführung ein Anschlussbein eingesteckt ist. Es wäre aber auch denkbar, dass die Antenne ein ähnliches Layout der Anschlussbeine aufweist wie der Steckverbinder, wobei lediglich die erste Durchführung für eine elektrische Kontaktierung genutzt wird, während die verbleibenden vier Durchführungen zur mechanischen Stabilisierung der Antenne verwendet werden. In diesem Fall können an dem elektrischen Bauteil nicht-leitende "Anschlussbeine" vorgesehen sein, die keinen elektrischen Kontakt zu aktiven Komponenten des elektrischen Bauteils herstellen.

Wenn ein elektrisches Bauteil in eine Steckfassung 1 nach den Figuren 1 bis 4 eingesteckt wird und ein Anschlussbein 12 den Bereich des Hohlzylinders 7 erreicht, so vergrößert das Anschlussbein 12 den Außendurchmesser des Hohlzylinders 7 in Richtungen quer zur Achse der Durchführung 5 geringfügig. Wenn die Rosette 10 in den Hohlzylinder 7 hineinragt, würde die Rosette 10 durch ein eingestecktes Anschlussbein 12 geweitet und würde das Material um das Anschlussmittel ebenso aufweiten. Zur Montage werden die Hohlzylinder 7 in passende zylinderförmige Ausnehmungen in einer Platine eingesteckt, wobei der Innendurchmesser des Ausnehmungen lediglich geringfügig größer ist als der Außendurchmesser der Hohlzylinder 7 ohne eingestecktem Anschlussbein und wobei die Innenseiten der Ausnehmungen mit einer leitfähigen Beschichtung versehen sind. Danach wird das elektrische Bauteil in die Steckfassung eingesteckt. Durch das Aufweiten der Hohlzylinder infolge des Einsteckens der Einschlussbeine in die Steckfassung, würden die Hohlzylinder gegen die Durchführung in der Platine drücken und damit sowohl einen elektrischen als auch einen mechanischen Kontakt zwischen Steckfassung und Platine herstellen. Auf diese Weise kann eine Verbindung zwischen einem elektrischen Bauteil und einer Platine hergestellt werden, ohne dass ein Lötvorgang notwendig wäre. Damit kann auch nach Fertigstellung eines SmartMeter-Gateways oder einer anderen Kommunikationseinheit ein elektrisches Bauteil samt Steckfassung angebracht werden. Mit dem Beispiel eines SmartMeter-Gateways und einer Antenne für das LMN würde eine Person, die das SmartMeter-Gateway installiert, zunächst eine Steckfassung in einen dafür vorgesehenen Bereich am SmartMeter-Gateway einstecken und danach entweder eine (interne) Antenne oder eine Fakra-Buchse für eine externe Antenne in die Steckfassung einstecken.

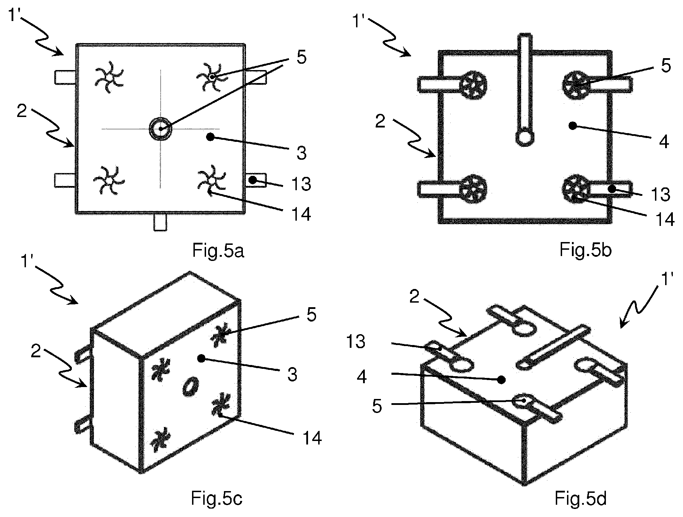

Die Figuren 5 bis 10 zeigen verschiedene Ansichten und Aspekte eines zweiten Ausführungsbeispiels einer erfindungsgemäßen Steckfassung, wobei hier die Anschlussmittel durch Lötfahnen 13 gebildet sind. Fig. 5a zeigt eine Draufsicht auf die Oberseite der Steckfassung 1'. Fig. 5b zeigt in einer Draufsicht auf die Unterseite der Steckfassung 1'. In Fig. 5c ist eine Schrägansicht der Steckfassung 1' mit Blick auf die Oberseite und in Fig. 5d eine Schrägansicht mit Blick auf die Unterseite dargestellt. Dieses zweite Ausführungsbeispiel gleicht dem ersten Ausführungsbeispiel mit Ausnahme der Anschlussmittel, wodurch die Steckfassung 1' als oberflächenmontiertes Bauelement - "surface mounted device" (SMD) - ausgebildet ist. Auch diese Steckfassung umfasst einen Grundkörper 2 mit Oberseite 3 und Unterseite 4. Von der Oberseite 3 zur Unterseite 4 erstrecken sich Durchführungen, die zur Aufnahme von Anschlussbeinen ausgebildet sind und die eine leitfähige Verbindung zwischen einem eingesteckten Anschlussbein und den Lötfahnen 13 herstellen. Die Anschlussbeine können dabei von beiden Seiten in die Durchführungen eingesteckt werden. In der Durchführung ist eine Blendenstruktur 14 vorgesehen, die ein Mittel zum kraftschlüssigen Festklemmen eines Anschlussbeins bildet.

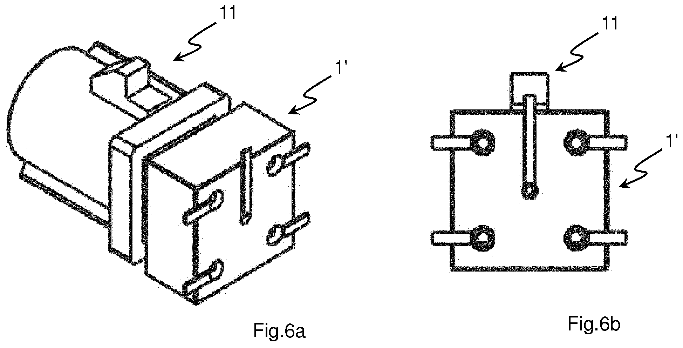

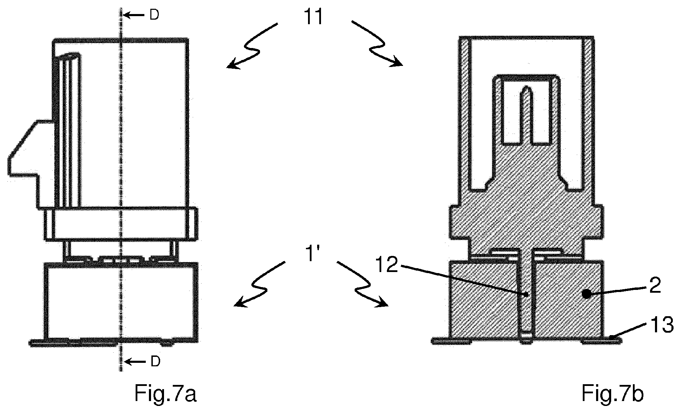

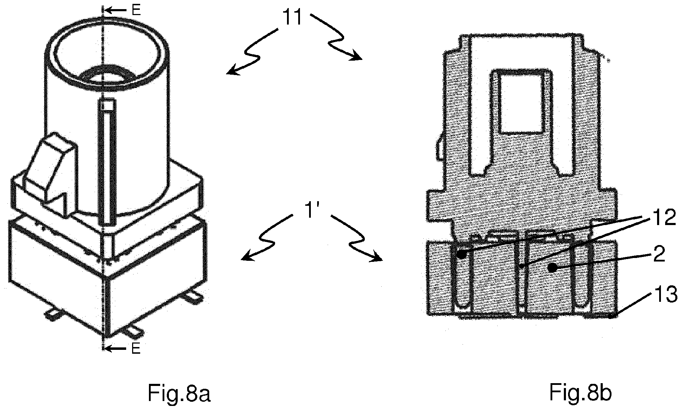

Fig. 6a zeigt in einer Schrägansicht mit Blick auf die Unterseite der Steckfassung 1' mit einem in die Steckfassung 1' vollständig eingesteckten Steckverbinder 11. Fig. 6b zeigt die Anordnung aus Fig. 6a in einer Draufsicht auf die Unterseite. Fig. 7a zeigt eine Seitenansicht der Steckfassung 1' mit vollständig in die Steckfassung 1' eingesteckten Steckverbinder 11. Fig. 7b zeigt eine Schnittdarstellung der Anordnung aus Fig. 7a entlang der Schnittlinie D-D. Fig. 8a zeigt eine Schrägansicht der Steckfassung 1' mit vollständig in die Steckfassung 1 eingesteckten Steckverbinder 11; Fig. 8b zeigt eine Schnittdarstellung entlang der Schnittlinie E-E gemäß Fig. 8b.

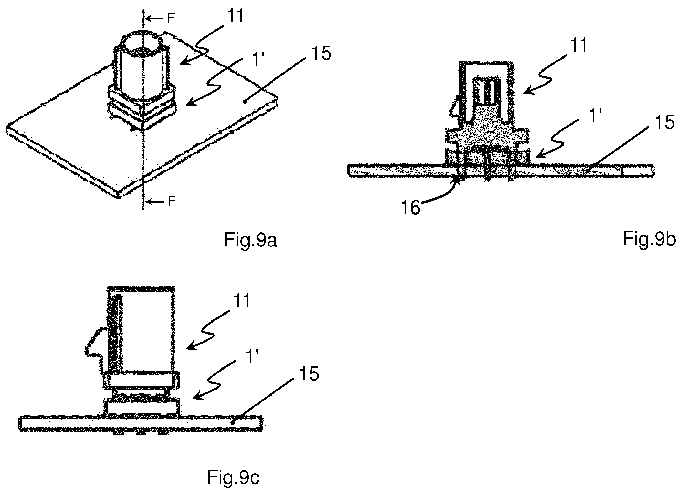

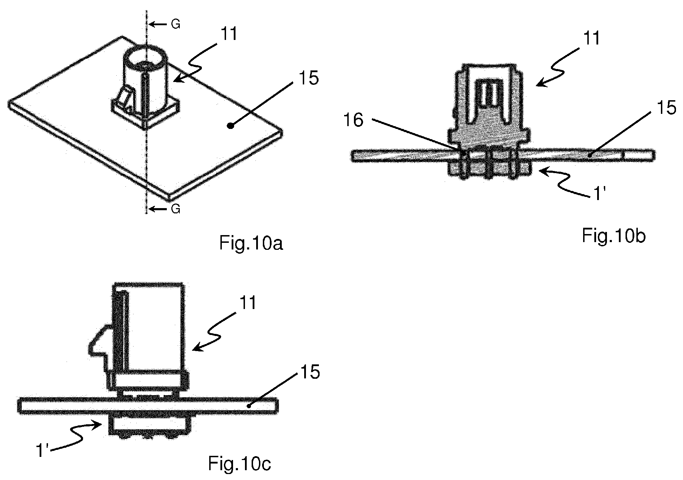

In den Figuren 9 und 10 sind verschiedene Anwendungsszenarien der Steckfassung 1' und einer Platine 15 dargestellt. Fig. 9a zeigt eine Schrägansicht einer Platine 15, Fig. 9b eine Schnittdarstellung entlang der Schnittlinie F-F gemäß Fig. 9a und Fig. 9c eine Seitenansicht. Die Lötfahnen 13 der Steckfassung 1' sind mit Leiterbahnen (der Übersichtlichkeit wegen nicht dargestellt) auf der Platine 15 verlötet, so dass eine feste Verbindung zwischen Steckfassung 1' und Platine 15 entsteht. Damit wird die Steckfassung 1' bereits beim Herstellvorgang der Platine 15 eingebaut. In der Ausführung nach Fig. 9 ist die Steckfassung 1' auf derselben Seite der Platine 15 angeordnet, so dass das elektrische Bauteil in der Oberseite der Steckfassung 1' eingesteckt ist. In der Ausführung nach Fig. 9 ist die Steckfassung sehr flach ausgebildet. Daher sind in der Platine 15 Durchgänge 16 ausgebildet, durch die die auf der Unterseite der Steckfassung herausragende Anschlussbeine hindurchgreifen können. Eine Verlötung der Anschlussbeine mit der Leitern auf der Platine 15 erfolgt jedoch nicht.

Fig. 10 zeigt verschiedene Ansichten einer Anordnung, bei der die Steckfassung 1' auf einer Seite der Platine 15 und der Steckverbinder 11 auf der anderen Seite der Platine 15 angeordnet ist. Fig. 10a zeigt eine Schrägansicht mit Blick auf die Seite des Steckverbinders 11, Fig. 10b ein Schnitt entlang der Schnittlinie G-G gemäß Fig. 10a und Fig. 10c eine Seitenansicht. Jedes Anschlussbein 12 des Steckverbinders 11 erstreckt sich durch ein in der Platine 15 ausgebildeter Durchgang 16. Bei der Anordnung nach Fig. 10 ist das elektrische Bauteil damit an der Unterseite der Steckfassung 1' eingesteckt, wobei die Steckfassung 1' für beide Ausgestaltungen (Einstecken von der Oberseite und Einstecken von der Unterseite) ausgebildet ist. Die Ausgestaltung nach Fig. 10 bietet den zusätzlichen Vorteil, dass ein Einbau eines Elektrischen Bauteils nach Fertigstellung der Platine 15 möglich ist, ohne sich jedoch - im Vergleich zu einem direkten Verlöten des Bauteils auf der Platine - negativ auf die Bauhöhe auswirken.

Hinsichtlich weiterer vorteilhafter Ausgestaltungen der erfindungsgemäßen Steckfassung wird zur Vermeidung von Wiederholungen auf den allgemeinen Teil der Beschreibung sowie auf die beigefügten Ansprüche verwiesen.

Schließlich sei ausdrücklich darauf hingewiesen, dass die voranstehend beschriebenen Ausführungsbeispiele der erfindungsgemäßen Steckfassung lediglich zur Erörterung der beanspruchten Lehre dienen, diese jedoch nicht auf die Ausführungsbeispiele einschränken.

### Bezugszeichenliste

- 1: Steckfassung
- 2: Grundkörper
- 3: Oberseite
- 4: Unterseite
- 5: Durchführung
- 6: Anschlussmittel
- 7: Hohlzylinder
- 8: Leitende Beschichtung
- 9: Innenzylinder
- 10: Rosette
- 11: Steckverbinder
- 12: Anschlussbein
- 13: Lötfahne
- 14: Blende
- 15: Platine
- 16: Durchgänge

## Patentansprüche

1. Steckfassung (1, 1') für ein elektrisches Bauteil, insbesondere einen Steckverbinder (11) oder eine Antenne, wobei das Bauteil mindestens ein Anschlussbein (12) aufweist,
wobei die Steckfassung (1, 1') einen Grundkörper (2) mit einer Oberseite (3), einer Unterseite (4) und mindestens einer Durchführung (5) zur Aufnahme des Anschlussbeins (12)/eines der Anschlussbeine (12) aufweist,
wobei an der Unterseite (4) des Grundkörpers (2) mindestens ein Anschlussmittel (6) zum elektrischen Kontaktieren mit mindestens einer Leiterbahn auf einer Platine (15), insbesondere einer Platine (15) für eine Kommunikationseinheit, angeordnet ist,
wobei sich die Durchführung/en (5) von einer Seite des Grundkörpers (2) zu einer anderen Seite des Grundkörpers (2) erstreckt/erstrecken und vorzugsweise derart ausgebildet ist/sind, dass das Bauteil in beide Enden der Durchführung/en (5) einsteckbar ist,
wobei in der Durchführung (5)/in mindestens einer der Durchführungen (5) ein elektrisch leitfähiger Bereich ausgebildet ist, der ein eingestecktes Anschlussbein (12) elektrisch kontaktiert und eine elektrisch leitfähige Verbindung zwischen dem eingesteckten Anschlussbein (12) und dem Anschlussmittel (6)/mindestens einem der Anschlussmittel (6) herstellt.

2. Steckfassung nach Anspruch 1, **dadurch gekennzeichnet, dass** sich die Durchführung (5)/jede der Durchführungen (5) von der Oberseite (3) zu der Unterseite (4) erstreckt, wobei der Grundkörper (2) vorzugsweise quaderförmig ausgebildet ist.

3. Steckfassung nach Anspruch 1 oder 2, **dadurch gekennzeichnet, dass** die Durchführung/en (5) zylinderförmig ausgestaltet sind.

4. Steckfassung nach einem der Ansprüche 1 bis 3, **dadurch gekennzeichnet, dass** der leitfähige Bereich durch eine leitfähige Beschichtung an der Innenwandung der Durchführung/en (5) gebildet ist.

5. Steckfassung nach einem der Ansprüche 1 bis 3, **dadurch gekennzeichnet, dass** der leitfähige Bereich durch eine in der/den Durchführung/en (5) angeordnete elektrisch leitfähige Hülse gebildet ist, die vorzugsweise form- und/oder kraftschlüssig mit der/den Durchführung/en (5) verbunden ist.

6. Steckfassung nach Anspruch 4 oder 5, **dadurch gekennzeichnet, dass** in der/den Durchführung/en (5) Mittel zum kraftschlüssigen Festklemmen des eingesteckten Anschlussbeins (12) ausgebildet sind, wobei die Mittel zum kraftschlüssigen Festklemmen vorzugsweise durch ein verformbares Material in Form einer Blende (14) oder einer Rosette (10) gebildet sind.

7. Steckfassung nach Anspruch 6, **dadurch gekennzeichnet, dass** die Mittel zum kraftschlüssigen Festklemmen des eingesteckten Anschlussbeins (12) elektrisch leitfähig sind oder selbst den elektrisch leitfähigen Bereich zumindest teilweise bilden.

8. Steckfassung nach einem der Ansprüche 1 bis 7, **gekennzeichnet durch** eine Anordnung der Steckfassung (1, 1') und des Bauteils auf einer Seite der Platine (15), wobei das Bauteil an der Oberseite (3) in die Steckfassung (1) eingesteckt ist.

9. Steckfassung nach einem der Ansprüche 1 bis 7, **gekennzeichnet durch** eine Anordnung der Steckfassung (1, 1') auf einer Seite der Platine (15) und des Bauteils auf der anderen Seite der Platine (15), wobei das/die Anschlussbein/e (12) des Bauteils **durch** in der Platine (15) ausgestaltete Durchgänge (16) geführt sind, und wobei das Bauteil an der Unterseite (4) des Grundkörpers (2) in die Steckfassung (1, 1') eingesteckt ist.

10. Steckfassung nach einem der Ansprüche 3 bis 9, **dadurch gekennzeichnet, dass** die Anschlussmittel (6) als Hohlzylinder (7) ausgestaltet sind, wobei jeder Hohlzylinder (7) einen koaxial zu einer der zylinderförmigen Durchführungen (5) ausgebildeten Innenzylinder (9) aufweist, dessen Durchmesser im Wesentlichen dem Durchmesser dieser Durchführung (5) entspricht, und wobei der Innenzylinder (9) die zylinderförmige Durchführung (5) in ihrer Länge erweitert.

11. Steckfassung nach einem der Ansprüche 5 bis 9, **dadurch gekennzeichnet, dass** die Anschlussmittel (6) durch einen Teil der Hülse gebildet sind, der über die Unterseite (4) des Grundkörpers (2) hinausragt.

12. Steckfassung nach Anspruch 10 oder 11, **dadurch gekennzeichnet, dass** das/die Anschlussmittel (6) derart ausgebildet ist/sind, dass ein in die zugehörige Durchführung (5) eingestecktes Anschlussbein (12) die Ausdehnung des Anschlussmittels (6) in einer Richtung quer zu der Durchführung (5) vergrößert, so dass das Anschlussmittel (6) in einem Durchgang in der Platine (15) eine kraftschlüssige Verbindung und eine elektrisch leitende Verbindung zu der Leiterbahn der Platine (14) herstellt, wobei die Leiterbahn zumindest teilweise an einer Innenseite des Durchgangs (5) angeordnet ist.

13. Steckfassung nach einem der Ansprüche 1 bis 9, **dadurch gekennzeichnet, dass** das/die Anschlussmittel (6) als Lötfahne/n (13) zum Verlöten mit mindestens einer Leiterbahn der Platine (10) ausgebildet ist/sind.

14. Steckfassung nach einem der Ansprüche 1 bis 13, **dadurch gekennzeichnet, dass** die Durchführungen (5) zum Einstecken der Anschlussbeine (12) eines zweipoligen Steckverbinders, insbesondere eines Koaxialsteckverbinders, ausgebildet sind.

15. Kommunikationseinheit, insbesondere SmartMeter-Gateway, mit einer Platine (15) und einer Steckfassung (1, 1') nach einem der Ansprüche 1 bis 14,
wobei die Kommunikationseinheit eine Verbindung zwischen zwei Netzwerken herstellt, insbesondere einem lokalen Netzwerk und einem Weitbereichsnetzwerk,
wobei die Steckfassung (1, 1') mit der Platine (15) verbunden ist,
wobei in die Steckfassung (1) Anschlussbeine (12) eines elektrischen Bauteils, insbesondere eines Steckverbinders (11) oder einer Antenne, einsteckbar sind, und
wobei das elektrische Bauteil als Schnittstelle zu einem der beiden Netzwerke dient.
